# EUROPEAN PATENT SPECIFICATION

(11) **EP 3 629 321 B1**
(45) Date of publication and mention of the grant of the patent: **28.02.2024**
(21) Application number: 19194178.0
(22) Date of filing: 28.08.2019
(51) Int. Cl.: G09G 3/3233

(54) **DISPLAY STRUCTURE, DISPLAY PANEL AND DISPLAY DEVICE**
ANZEIGESTRUKTUR, ANZEIGETAFEL UND ANZEIGEVORRICHTUNG
STRUCTURE D'AFFICHAGE, PANNEAU D'AFFICHAGE ET DISPOSITIF D'AFFICHAGE

(30) Priority: 28.09.2018 CN 201811143397
(43) Date of publication of application: 01.04.2020
(73) Proprietor: Beijing Xiaomi Mobile Software Co., Ltd., Beijing 100085 (CN)
(72) Inventor: BIAN, Qingfang, Beijing, 100085 (CN)
(74) Representative: Hughes, Andrea Michelle

(56) References cited:
- EP-A1- 1 146 501
- US-A1- 2004 233 140
- US-A1- 2008 165 267

## Description

### FIELD

The present disclosure relates to a field of display technologies, and more particularly to a display structure, a display panel, and a display device.

### BACKGROUND

A mobile terminal is integrated with more and more functions to improve its intelligence. A photographing function is one of them. In order to implement the photographing function, an image collection device needs to be integrated in the mobile terminal. Also, a hole needs to be opened in the front of the mobile terminal for installing the image collection device to make sure that the image collection device can collect an image at the front of the mobile terminal, which not only affects the aesthetics of the mobile terminal, but also reduces an area ratio of a display area in the front of the mobile terminal.
In the reference US 2004/233140 A1 "Electronic device, element substrate, electro-optical device, method of producing the electro-optical device, and electronic apparatus" written by JO HIROAKI et al, to provide an electronic circuit, an element substrate, an electronic device, an electro-optical device, and an electronic apparatus, which make it possible to perform a precise controlling operation even if manufacturing variations occur, a circuit formation area is an annular formation area of a pixel of a display panel, and does not include a substantially central portion of the pixel. A light emission area is provided in the substantially central portion. One drive circuit is formed in the circuit formation area, and four organic elements OLED are formed in the light emission area. The drive circuit and the organic elements OLED are connected parallel to each other with wirings.
In the reference EP 1 146 501 A1 "Display device with memory integrated on the display substrate" written by MATSUEDA YOJIRO et al, To obtain a display device taking into consideration layout efficiency, etc., in the case of integrally forming a peripheral circuit on a glass substrate. Integrated on a substrate and integrally formed therewith an active-matrix LCD section 2 having a plurality of scanning lines and a plurality of data lines formed in a grid form corresponding to dots, and active elements according to the respective intersections to perform display control using a liquid crystal by driving the scanning lines and the data lines, a row decoder 31 for selecting the scanning lines, a memory cell section 56 having memory cells that are in the number capable of storing an image signal for display control of dots in at least one row of a display drive section and allocated corresponding to the length in the row direction of the display drive section, a column decoder section 51 for selecting a memory cell to be stored with an inputted image signal, a column selection switch section 53 switching on the basis of a selection by the column decoder section 51 and the image signal and storing the image signal to the memory cell selected, and a k-bit DAC section 41 for driving a data line on the basis of the image signal stored in the memory cell section.
Document US20080165267A1 discloses an image capture and integrated display apparatus.

### SUMMARY

The present disclosure provides a display structure, a display panel, and a display device.

According to a first aspect of embodiments of the present disclosure, a display structure is provided as claimed in claim 1.

[deleted].

[deleted].

[deleted].

In an embodiment, the first driving circuit includes a driving transistor, and the organic light emitting diode includes a first electrode, a second electrode, and an organic light emitting layer provided between the first electrode and the second electrode. The driving transistor in the i^{th} first driving circuit is connected to the first electrode in each sub-pixel of the i^{th} color.

In an embodiment, the first electrodes in neighboring isochromatic sub-pixels are connected.

[deleted].

[deleted].

In an embodiment, the control unit is configured to control one or more organic light emitting diodes in one or more pixels locating in the same display segment to emit or extinguish light simultaneously.
In an embodiment, the one or more pixels in the preset position are part of pixels in the preset pattern, or all pixels in the preset pattern.

According to a second aspect of embodiments of the present disclosure, a display panel is provided as claimed in claim 6.

According to a third aspect of embodiments of the present disclosure, a display device is provided as claimed in claim 7.

It should be understood that the general description above and the detailed description below are only exemplary and explanatory, and are not intended to limit the present disclosure.

### BRIEF DESCRIPTION OF THE DRAWINGS

The accompanying drawings, which are incorporated into and constitute a part of the specification, illustrate embodiments of the present disclosure, and together with the description, serve to explain principles of the present disclosure.
Fig. 1 is a schematic diagram illustrating a display structure by way of background.
Fig. 2 is a schematic diagram illustrating a display structure according to an embodiment of the present disclosure.
Fig. 3 is a schematic diagram illustrating a display structure by way of background.
Fig. 4 is a schematic diagram illustrating a cross section of a display structure according to an embodiment of the present disclosure.
Fig. 5 is a schematic diagram illustrating a cross section of a display structure according to another embodiment of the present disclosure.
Fig. 6 is a schematic diagram illustrating a driving circuit according to embodiments of the present disclosure.
Fig. 7 is a schematic diagram illustrating a display panel according to embodiments of the present disclosure.
Fig. 8 is a schematic diagram illustrating a wiring of a display panel according to embodiments of the present disclosure.
Fig. 9 is a block diagram illustrating a device for displaying according to embodiments of the present disclosure.

### DETAILED DESCRIPTION

Illustration will be made in detail here to exemplary embodiments. Examples of embodiments are illustrated in the accompanying drawings. When description relates to the accompanying drawings, the same numbers in different accompanying drawings represent the same or similar elements, unless otherwise specified, and the implementations described below in the exemplary embodiments do not represent all implementations consistent with the present disclosure. Instead, they are merely examples of devices and methods described in the accompanying claims and consistent with aspects of the present disclosure.

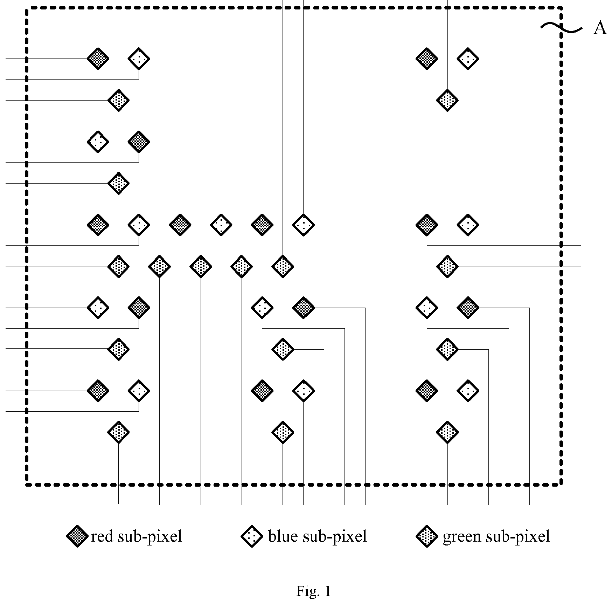

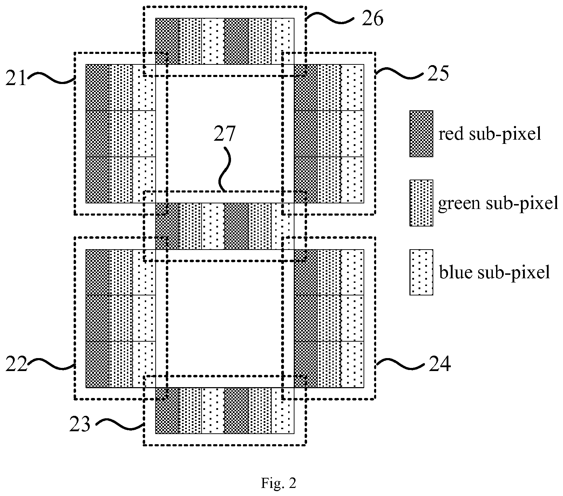

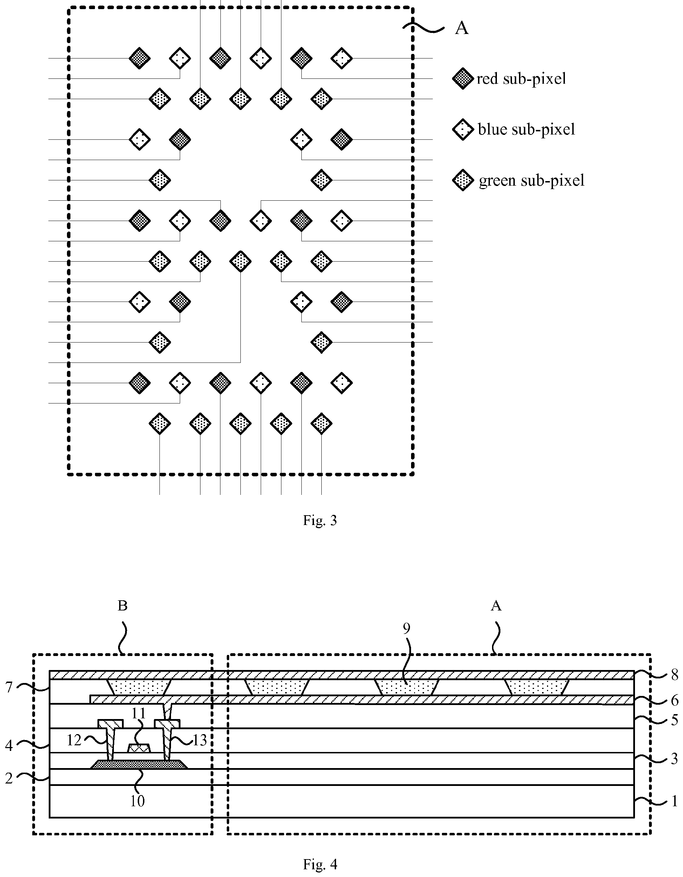

Fig. 1 is a schematic diagram illustrating a display structure by way of background. Fig. 2 is a schematic diagram illustrating a display structure according to an embodiment of the present disclosure. Fig. 3 is a schematic diagram illustrating a display structure by way of background. As illustrated in Fig. 1, Fig. 2 and Fig. 3, the display structure includes: a plurality of pixels and a plurality of first driving circuits.

The plurality of pixels are provided in a first area A of the display structure. The plurality of pixels are arranged based on a preset pattern. An area of the preset pattern is less than that of the first area A. Each pixel includes sub-pixels of a plurality of colors, and each sub-pixel includes an organic light emitting diode.

The plurality of first driving circuits are provided in a second area outside the first area A, and are connected to all the organic light emitting diodes. The plurality of first driving circuits are configured to drive all the organic light emitting diodes to emit light.

In an embodiment, each pixel includes at least a red sub-pixel, a green sub-pixel and a blue sub-pixel. The arrangement way of the red sub-pixels, the green sub-pixels and the blue sub-pixels illustrated in Fig. 1. which shows arrangement similar to crystals, is by way of background only. Each pixel includes a red sub-pixel, a green sub-pixel and two blue sub-pixels. In the arrangement way of the sub-pixels according to the invention, as illustrated in Fig. 2, the sub-pixels may be arranged in a matrix form, in which, each pixel includes a red sub-pixel, a green sub-pixel and a blue sub-pixel.

As illustrated in Fig. 2, the preset pattern is a character "8" structured by seven display segments 21-27.

Since the area of the preset pattern is less than that of the first area, the pixels do not fully fill the first area. Compared to the situation where the pixels fully fill the first area, since there are fewer pixels in this embodiment, a number of first driving circuits configured to drive the organic light emitting diodes may be less, thereby to facilitate providing the first driving circuits in the second area (not shown) outside the first area.

For example, the second area may be provided along edges of the first area, or the second area may be provided at one side of the first area, which may be provided based on the preset pattern.

According to embodiments of the present disclosure, since the first driving circuit contains a shading structure such as the transistor or the capacitor, but the organic light emitting diode is transparent, the sub-pixels are provided in the first area, and the first driving circuits are provided in the second area outside the first area, such that the display structure at the first area is close to transparency; and the plurality of pixels in the first area are arranged based on the preset pattern, such that the display structure at the first area may has a certain display function, for example, the display structure may display the preset pattern.

Based on the above, in a display device containing the display structure, if it is desired to provide an image collection device in the display device, the image collection device may be provided under the first area of the display structure. Since the first area is close to transparency, it can be ensured that the image collection device is not shaded, and the first area still has a certain display effect and also belongs to the part of the display area, which is beneficial to improve a ratio of the display area in the front of the display device, and makes the display device look more attractice on the whole.

In an embodiment, each first driving circuit is connected to one of the organic light emitting diodes correspondingly.

In an embodiment, one first driving circuit may drive one organic light emitting diode to emit light. Based on this, different organic light emitting diodes may be controlled independently, to facilitate partly displaying the plurality of pixels based on displaying the preset pattern, such that richer patterns may be displayed.

In an embodiment, at least one first driving circuit is connected to multiple organic light emitting diodes correspondingly.

In an embodiment, the multiple organic light emitting diodes may be driven by one first driving circuit. Based on this, the multiple organic light emitting diodes may be connected to one first driving circuit by a wire, which may be beneficial to reduce a wiring layout design. Since the wire has influence on the transmittance of the display structure, the first area having higher transmittance may be further guaranteed.

Corresponding to the situation of embodiments illustrated in Fig. 2, the organic light emitting diodes in the pixels of one display segment are driven by the first driving circuits, in which the number of the first driving circuits corresponds to the number of the colors of the sub-pixels. For example, for one of the seven display segments, if the pixels contain sub-pixels of three colors that are red, green and blue, the display segment may be driven by three first driving circuits. Correspondingly, the seven display segments may be driven by twenty-one first driving circuits, such that the pixels in the display segments may be lighted up or extinguished simultaneously as a whole, which is beneficial to improve the viewing effect.

In an embodiment, each pixel includes sub-pixels of n colors, and each sub-pixel includes the organic light emitting diode.

The plurality of first driving circuits include n first driving circuits, and the i^{th} first driving circuit of the n first driving circuits is configured to drive the organic light emitting diode in each sub-pixel of the i^{th} color to emit light. 1≤i≤n, i and n are integers, and n>1.

On the basis that the first driving circuits are connected to the organic light emitting diodes by a one-to-more way, the organic light emitting diodes in the sub-pixels of the same color are connected to one first driving circuit. Taking n=3 as an example, the three first driving circuits may achieve driving the organic light emitting diodes, such that the wiring layout design may be further reduced, which is beneficial to improve the transmittance of the first area.

In an embodiment, the first driving circuit includes a driving transistor, and the organic light emitting diode includes a first electrode, a second electrode, and an organic light emitting layer provided between the first electrode and the second electrode.

The driving transistor in the i^{th} first driving circuit is connected to the first electrode in each sub-pixel of the i^{th} color.

In an embodiment, the structure of the organic light emitting diode may provide an organic light emitting layer between the first electrode and the second electrode, in which the first electrode is an anode and the second electrode is a cathode, or the first electrode is a cathode and the second electrode is an anode. The following mainly exemplifies the situation that the first electrode is the anode and the second electrode is the cathode.

For different organic light emitting diodes, the first electrodes are provided on the same side of the organic light emitting diodes. Therefore, driving the plurality of sup-pixels is implemented by the driving transistor connecting to the plurality of first electrodes, the structure of which is simple compared to the driving transistor connecting the first electrodes of some sub-pixels and the second electrodes of some other sub-pixels.

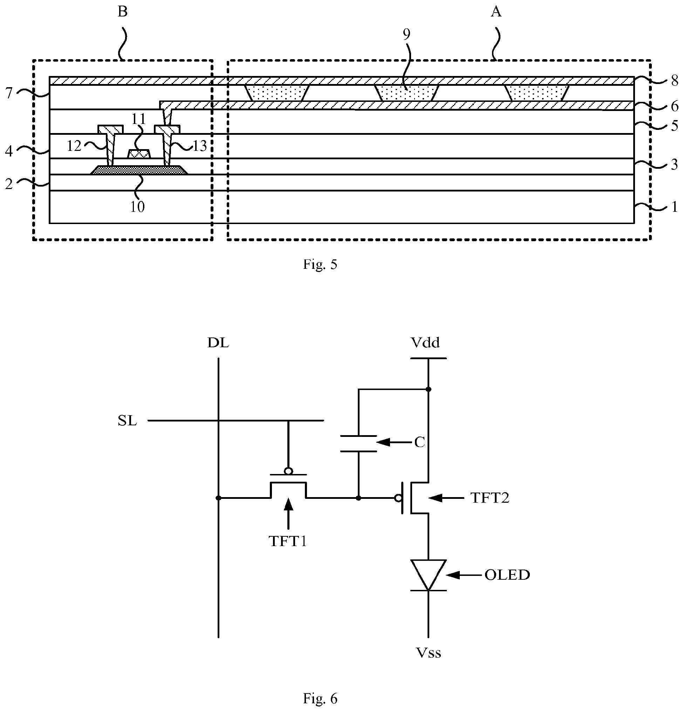

Fig. 4 is a schematic diagram illustrating a cross section of a display structure according to an embodiment of the present disclosure. Fig. 5 is a schematic diagram illustrating a cross section of a display structure according to another embodiment of the present disclosure. As illustrated in Fig. 4 and Fig. 5, the first electrodes 6 of the neighboring sub-pixels of the same color are connected.

In an embodiment, as illustrated in Fig. 4, the display structure may include, from bottom to top: a substrate 1, a buffer layer 2, a gate insulator layer 3, an interlayer dielectric layer 4, a planar layer 5, a first electrode 6, a pixel define layer 7, and a second electrode 8. A driving transistor includes an active layer 10, a gate 11, a source 12 and a drain 13. An organic material layer 9 is provided between the first electrode 6 and the second electrode 8.

Each organic material layer 9 corresponds to a sub-pixel, and the first electrodes 6 of the plurality of sub-pixels of the same color are connected. According to this, when the first electrodes 6 are formed, the plurality of sub-pixels of the same color may be connected by connecting the first electrodes 6, and the structure connecting the first electrodes 6 of the sub-pixels may be formed by the driving transistor connecting to the first electrode 6 of any sub-pixel, which is beneficial to simplify the connecting structure between the driving transistor and the first electrodes 6.

The driving transistor may be connected to the plurality of sub-pixels of the same color based on other methods. For example, in the situation that the first electrodes of the plurality of sub-pixels of the same color are not connected, a hole may be provided in the position corresponding to the first electrode of each sub-pixel, and then the drain of the driving transistor is extended to each hole, to implement electric connection with the first electrode of each hole.

It should be noted that, in the embodiment illustrated in Fig. 4, the organic material layer 9 is provided above the driving transistor. That is, the second area B where the driving transistor is located may further emit light. In the embodiment illustrated in Fig. 5, an organic material layer is not provided above the driving transistor based on the need. As illustrated in Fig. 5, the second area B where the first driving transistor is located does not emit light.

In an embodiment, the display structure further includes a control unit.

The control unit is connected to the plurality of first driving circuits. The control unit is configured to control the plurality of first driving circuits to drive one or more organic light emitting diodes at one or more pixels of a preset position in the preset pattern to emit light.

In an embodiment, the control unit may enable the first driving circuits to drive the one or more organic light emitting diodes at the one or more pixels of the preset position in the preset pattern to emit light by controlling the first driving circuits. According to this, the plurality of pixels arranged in the preset pattern may emit light at the preset position in the preset pattern. The preset position may be provided in advance before controlling the first driving circuits, such that the one or more pixels may be controlled to emit light based on the preset position provided in advance, to facilitate displaying the content to satisfy the need.

[deleted].

The preset pattern includes seven display segments, and each display segment includes a plurality of adjacent pixels.

The plurality of adjacent pixels form the display segment, and then the plurality of display segments form the preset pattern. According to this, the control unit controls one or more display segments which are located at the preset position to light, such that the one or more display segments form the content needed.

As illustrated in Fig. 2, the pattern displayed equates to seven display segments, which may display one of 0-9 numbers and a plurality of English characters by controlling one of the display segments to emit or extinguish light. For example, the organic light emitting diodes at the pixels of the two vertical display segments 24 and 25 in the right of the seven display segments may be controlled to emit light, such that the pattern displayed is "1" and is not "8". And the pattern may include a plurality of groups of the above seven display segments. For example, a pattern includes two groups of the above seven display segments, and then one of 0-99 numbers may be displayed.

In an embodiment, the control unit is configured to control one or more organic light emitting diodes in one or more pixels locating in the same display segment to emit or extinguish light simultaneously.

In the embodiment, the control unit may control the one or more organic light emitting diodes in the one or more pixels locating in the same display segment to emit or extinguish light simultaneously. According to this, it may ensure that, when a certain display segment is controlled to emit or extinguish light, this display segment may be emitted or extinguished as a whole, and may not be emitted or extinguished a pixel by a pixel, which is beneficial to ensure a viewing effect that the one or more pixels in the display segment are as a whole.

In an embodiment, the one or more pixels in the preset position are part of pixels in the preset pattern, or all pixels in the preset pattern.

In an embodiment, the pixels of the preset position, which are controlled to emit light by the control unit, may be part of pixels in the preset pattern, and may further be all the pixels in the preset pattern. That is, part of areas in the preset pattern may be controlled to emit light, or all the areas in the preset pattern may be controlled to emit light.

Fig. 6 is a schematic diagram illustrating a driving circuit according to embodiments of the present disclosure. As illustrated in Fig. 6, the driving circuit includes: a switching transistor TFT1, a driving transistor TFT2 and a capacitance C.

A first terminal of the switching transistor TFT1 is connected to a scan line SL, and a second terminal of the switching transistor TFT1 is connected to a data line DL.

A first terminal of the driving transistor TFT2 is connected to a third terminal of the switching transistor TFT1, a second terminal of the driving transistor TFT2 is connected to a preset voltage terminal Vdd, and a third terminal of the driving transistor TFT2 is connected to an organic light emitting diode OLED.

A first terminal of the capacitance C is connected to the first terminal of the driving transistor TFT2, and a second terminal of the capacitance C is connected to the second terminal of the driving transistor TFT2.

In an embodiment, the above first terminal may be the gate, the second terminal may be the source, and the third terminal may be the drain. The scan line SL inputs a signal to the gate of the switching transistor TFT1, such that the switching transistor TFT1 is turned on. A signal in the data line DL is transmitted from the source of the switching transistor TFT1 to the drain of the switching transistor TFT1, and is applied to the gate of the driving transistor TFT2, such that the driving transistor TFT2 is turned on. A signal of the preset voltage terminal Vdd passes through the driving transistor TFT2 to generate a current signal, and the current signal is inputted to the organic light emitting diode OLED, such that the organic light emitting diode OLED emits light.

It should be noted that the structure of the driving circuit is not limited to the situation in embodiments illustrated in Fig. 6. For example, the structure may further adopt structures or processing such as 6T1C, 7T1C or NMOS (N-Metal-Oxide-Semiconductor), CMOS (Complementary-Metal-Oxide-Semiconductor).

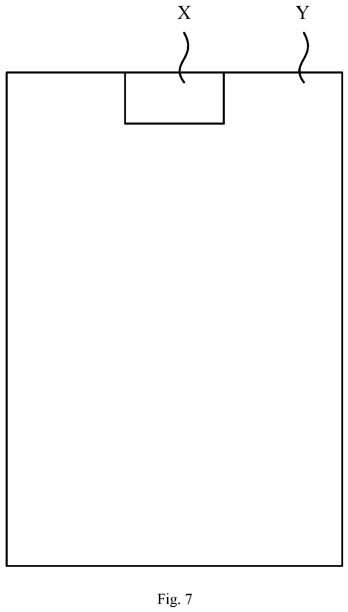

Fig. 7 is a schematic diagram illustrating a display panel according to embodiments of the present disclosure. As illustrated in Fig. 7, the display panel includes a display structure X according to any of the above embodiments, and an effective emitting area Y

The effective emitting area Y is provided with a plurality of effective emitting pixels and a plurality of second driving circuits. Each effective emitting pixel includes a plurality of sub-pixels, and the sub-pixels in the effective emitting area Y are provided to correspond to the second driving circuits one by one.

In an embodiment, since sub-pixels correspond to second driving circuits one by one in the effective emitting area of the display panel, for example, the driving transistor may be provided under the organic emit layer of the sub-pixel, such that each sub-pixel may be controlled independently, to implement to display the pattern in the effective emitting area.

In this situation, if it is desired to provide an image collection device under the display panel, the image collection device may be provided under the first area of the display structure. And since the first area of the display structure is close to transparency, and has a certain display effect, both the effective emitting area and the first area of the display structure may be taken as the display area, such that the area provided with the image collection device may further be taken as the display area, which is beneficial to improve a ratio of a display area in the front of the display device, and enables the display device more attractive on the whole.

It should be noted that, in the embodiment illustrated in Fig. 4, the organic material layer 9 is provided above the driving transistor. That is, the second area B where the first driving circuit is located may further emit light. In this situation, the driving transistors in the display structure and the driving transistors of the second driving circuits in the effective emitting area may be reused.

In the embodiment illustrated in Fig. 5, an organic material layer is not provided above the driving transistor, and then the driving transistor in the display structure may be provided in a frame area of the display panel, to avoid the driving transistor affecting the transmittance.

In an embodiment, on the basis of the embodiments illustrated in Fig. 7, there may be the following embodiments.

In an embodiment, each first driving circuit is connected to one of the organic light emitting diodes correspondingly.

In an embodiment, at least one first driving circuit is connected to multiple organic light emitting diodes correspondingly.

In an embodiment, each pixel includes sub-pixels of n colors, and each sub-pixel includes the organic light emitting diode.

The plurality of first driving circuits include n first driving circuits, and the i^{th} first driving circuit of the n first driving circuits is configured to drive the organic light emitting diode in each sub-pixel of the i^{th} color to emit light. 1≤i≤n, i and n are integers, and n>1.

In an embodiment, the first driving circuit includes a driving transistor, and the organic light emitting diode includes a first electrode, a second electrode, and an organic light emitting layer provided between the first electrode and the second electrode.

The driving transistor in the i^{th} first driving circuit is connected to the first electrode in each sub-pixel of the i^{th} color.

In an embodiment, the first electrodes in neighboring sub-pixels of the same color are connected.

In an embodiment, the display structure further includes a control unit.

The control unit is connected to the plurality of first driving circuits, and configured to control the plurality of first driving circuits to drive one or more organic light emitting diodes at one or more pixels of a preset position in the preset pattern to emit light.

In an embodiment, the display panel further includes: a gate driving circuit and a data signal circuit.

The gate driving circuit is configured to input gate driving signals to driving circuits.

The data signal circuit is configured to input data signals to driving circuits.

The driving circuits may include the first driving circuits in the display structure, and further include the second driving circuits in the effective emitting area.

In an embodiment, the gate driving circuit may input the gate driving signal to the driving circuit through the scan line. For n first driving circuits in the above display structure, the gate driving signal may be inputted to the n first driving circuits through one scan line, or the gate driving signal may be inputted to the n first driving circuits one by one through n scan lines. In addition, for x first driving circuits in the n first driving circuits, the gate driving signal may be inputted by one scan line, and for n-x first driving circuits in the n first driving circuits, the gate driving signal may be inputted to the n-x first driving circuits by n-x scan lines one by one, in which x is a positive integer less than n.

For the plurality of second driving circuits in the effective emit area of the above display panel, the gate driving signal may further be inputted by the scan line, and the scan lines for inputting the gate driving signal to the second driving circuits in the effective emit area of the display panel may be reused to input the gate driving signal to the first circuits in the display structure described above.

The scan lines for inputting the gate driving signal to the second driving circuits in the effective emit area of the display panel may be different from the scan lines for inputting the gate driving signal to the first driving circuits in the above display structure. For example, the gate driving signal is input to the first driving circuits in the above display structure by one scan line, and the gate driving signal is input to the second driving circuits in the effective emit area of the display panel by m scan lines. The scan line for inputting the gate driving signal to the first driving circuits in the display structure may be arranged anywhere in the m+1 scan lines, such as arranged as the first line or arranged as the (m+1)^{th} line.

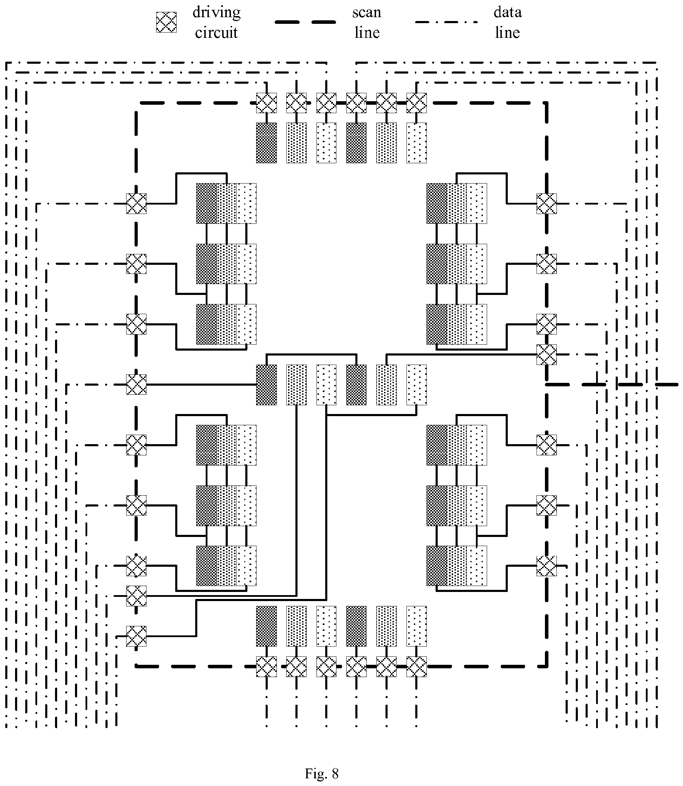

Fig. 8 is a schematic diagram illustrating a wiring of a display panel according to embodiments of the present disclosure.

As illustrated in Fig. 8, on the basis of Fig. 2, at least one driving circuit is correspondingly connected to multiple organic light emitting diodes. For part of display segments, the sub-pixels of the same color in each display segment are connected to the same driving circuit, such as all the red sub-pixels in the display segment 21 are connected to the same driving circuit, all the green sub-pixels are connected to the same driving circuit, and all the blue sub-pixels are connected to the same driving circuit.

For another part of the display segments, each driving circuit may be correspondingly connected to one of the organic light emitting diodes. For example, the sub-pixels in the display segment 23 and the driving circuits are in a one-to-one correspondence relationship.

Further, as illustrated in Fig. 8, all the driving circuits may be connected to GOA (Gate IC On Array) of the display panel by one scan line SL, and each driving circuit may be respectively connected to the data signal circuit of the display panel by a data line SL.

In addition, it should be noted that, for the first driving circuits in the display structure and the second driving circuits in the effective emit area, the gate driving signal may be inputted through the same gate driving circuit, or may be inputted through different gate driving circuits; the data signal may be inputted through the same data signal circuit, or may be inputted through different data signal circuits.

In an embodiment, the display panel further includes an array substrate.

The gate driving circuit is provided in the array substrate.

In an embodiment, the gate driving circuit (Gate IC) may be provided in the array substrate, to form a GOA structure.

Embodiments of the present disclosure further provide a display device, including the display panel according to any of the above embodiments, and an image collection device.

The image collection device is provided in the first area, and located on a side of the display structure away from a light emitting direction.

In an embodiment, the image collection device may be provided under the display panel. For example, the image collection device may be provided at the first area of the display area, and be located on the side of the display structure away from the light emitting direction. Since the first area is close to transparency, and has the display function to some extent, both the effective emit area and the first area of the display structure may be used as the display area, such that the area provided with the image collection device may further be taken as the display area, which is beneficial to improve a ratio of a display area in the front of the display device, and enables the display device more attractive on the whole.

In an embodiment, the display device further includes a sensor.

The sensor is provided in the first area, and located on a side of the display structure away from a light emitting direction.

In an embodiment, if it is desired to provide a sensor in the display device, the sensor may be provided in the first area of the display area, and located on the side of the display structure away from the light emitting direction, such that the area provided with the sensor may further be the display area, which is beneficial to improve a ratio of a display area in the front of the display device, and makes the display device look more attractive on the whole. The sensor may include a distance sensor, an ambient light sensor and the like.

It should be noted that, the above display device may be a mobile terminal, such as a phone, a table computer, an intelligent wearable device, or may further be other types of devices, such as a television and a computer screen.

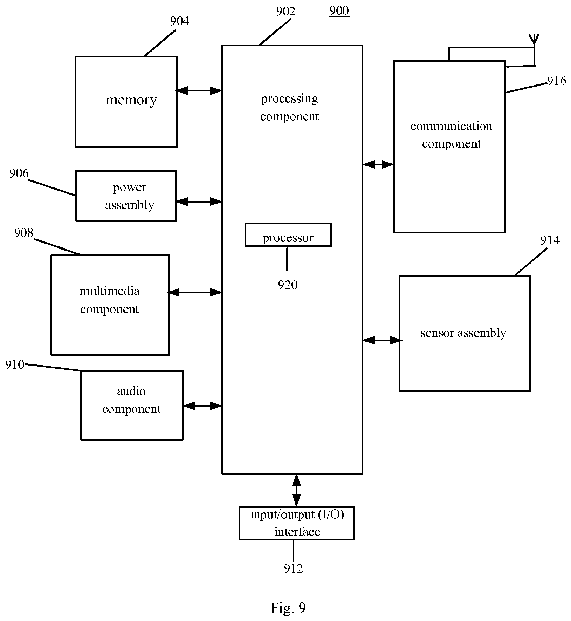

Fig. 9 is a block diagram illustrating a device 900 for displaying according to embodiments of the present disclosure. For example, the device 900 may be a mobile phone, a computer, a digital broadcast device, a messaging device, a game console, a tablet device, a medical device, a fitness device, a personal digital assistant, and the like.

As illustrated in Fig. 9, the device 900 may include one or more components as follows: a processor component 902, a memory 904, a power assembly 906, a multimedia component 908, an audio component 910, an input/output (I/O) interface 912, a sensor assembly 914, and a communication operation 916. The device 900 further includes a display panel as described in any of the embodiments.

The processing component 902 usually controls overall operation of the device 900, such as operations associated with display, telephone calls, data communications, camera operations, and recording operations. The processing component 902 may include one or more processors 920 to execute instructions, to complete all or part of the operations in the above described methods. In addition, the processing component 902 may include one or more modules which facilitate interaction between the processing component 902 and other components. For instance, the processing component 902 may include a multimedia module to facilitate interaction between the multimedia component 908 and the processing component 902.

The memory 904 is configured to store various types of data to support operations at the device 900. Examples of such data include instructions for any applications or methods operated on the device 900, contact data, phonebook data, messages, pictures, videos, etc. The memory 904 may be implemented using any type of volatile or non-volatile storage devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power assembly 906 provides power to various components of the device 900. The power assembly 906 may include a power management system, one or more power supplies, and other components related to generation, management, and distribution of power in the device 900.

The multimedia component 908 includes a screen that provides an output interface between the device 900 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a duration and a pressure associated with the touch or swipe action. In some embodiments, the multimedia component 908 includes a front camera and/or a rear camera. When the device 900 is in an operation mode, such as a photographing mode or a video mode, the front camera and/or the rear camera may receive external multimedia data. Each of the front and rear cameras may be a fixed optical lens system or have a focus and optical zoom capability.

The audio component 910 is configured to output and/or input audio signals. For example, the audio component 910 includes a microphone (MIC) configured to receive an external audio signal when the device 900 is in an operating mode, such as a call mode, a recording mode, and a speech recognition mode. The received audio signal may be further stored in the memory 904 or transmitted via the communication component 916. In some embodiments, the audio component 910 further includes a loudspeaker, which is configured to output the audio signals.

The I/O interface 912 provides an interface between the processing component 902 and a peripheral interface module, such as a keyboard, a click wheel, a button and the like. The buttons may include, but are not limited to, a home button, a volume button, a starting button, and a locking button.

The sensor assembly 914 includes one or more sensors for providing status assessments of various aspects of the device 900. For example, the sensor assembly 914 may detect an open/closed state of the device 900, relative positioning of the components, such as the display and the keypad of the device 900, a change in position of the device 900 or of a component of the device 900, presence or absence of user contact with that device 900, an orientation or an acceleration/deceleration of the device 900, and a change in temperature of the device 900. The sensor assembly 914 may include a proximity sensor configured to detect the presence of nearby objects without any physical contact. The sensor assembly 914 may also include a light sensor, such as a CMOS or CCD image sensor, for use in imaging applications. In some embodiments, the sensor assembly 914 may also include an accelerometer sensor, a gyroscope sensor, a magnetic sensor, a pressure sensor, or a temperature sensor.

The communication component 916 is configured to facilitate wired or wireless communication between the device 900 and other devices. The device 900 can access a wireless network based on a communication standard, such as Wi-Fi, 2G, or 3G, or a combination of them. In an exemplary embodiment, the communication component 916 receives a broadcast signal or broadcast related information from an external broadcast management system via a broadcast channel. In an exemplary embodiment, the communication component 916 further includes a near field communication (NFC) module to facilitate short-range communication. For example, the NFC module may be implemented based on a radio frequency identification (RFID) technology, an infrared data association (IrDA) technology, an ultra-wideband (UWB) technology, a Bluetooth (BT) technology, and other technologies.

In exemplary embodiments, the device 900 may be implemented with one or more application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the methods described above.

In exemplary embodiments, there is also provided a non-transitory computer readable storage medium including instructions, such as the memory 904 including instructions. The instructions can be executed by the processor 920 of the device 900 to perform the methods described above. For example, the non-transitory computer readable storage medium may be a ROM, a random access memory (RAM), a CD-ROM, a magnetic tape, a floppy disk, an optical data storage device, and the like.

The application is intended to cover any variations, uses or adaptations of the present disclosure. The variations, uses or adaptations follow general principles of the present disclosure and include common knowledge or conventional techniques in the field of the technology not disclosed by the present disclosure. The specification and embodiments are merely exemplary, and the true scope of this invention is indicated by the claims below.

## Claims

1. A display structure (X), comprising:
a plurality of pixels, provided in a first area (A) of the display structure, wherein the plurality of pixels are arranged in a 7-segment display pattern comprising seven display segments (21, 22, 23, 24, 25, 26, 27), each display segment comprising a plurality of adjacent pixels, an area of the preset pattern is less than that of the first area, each pixel comprises sub-pixels of n colors, and each sub-pixel comprises an organic light emitting diode, OLED; and
a plurality of first driving circuits provided in a second area (B) outside the first area, wherein the plurality of first driving circuits comprises n first driving circuits, the plurality of first driving circuits are connected to the organic light emitting diodes, and an i^{th} first driving circuit of the n first driving circuits is configured to drive the organic light emitting diodes in each sub-pixel of an i^{th} color to emit light, where i and n are integers, and n>1;
for part of the display segments, all the sub-pixels of a same color in each display segment in the first area are connected to the same one of the first driving circuits in the second area outside the first area; and
a control unit connected to the plurality of first driving circuits, the control unit being configured to control the plurality of first driving circuits to drive one or more organic light emitting diodes at one or more pixels of a preset position in the preset pattern to emit light.

2. The structure according to claim 1, wherein each of the plurality of first driving circuits comprises a driving transistor, TFT2, and each of the organic light emitting diodes comprises a first electrode (6), a second electrode (8), and an organic light emitting layer provided between the first electrode and the second electrode;
wherein the driving transistor in the i^{th} first driving circuit is connected to the first electrode in each sub-pixel of the i^{th} color.

3. The structure according to claim 2, wherein the first electrodes of neighboring sub-pixels of the same color are connected.

4. The structure according to claim 1, wherein the control unit is configured to control one or more organic light emitting diodes in one or more pixels located in the same display segment to emit or extinguish light simultaneously.

5. The structure according to any preceding claim, wherein the one or more pixels in the preset position are part of pixels in the preset pattern, or all pixels in the preset pattern.

6. A display panel, comprising:
the display structure (X) according to any one of claims 1 to 5; and
an effective emitting area (Y), wherein the effective emitting area is provided with a plurality of effective emitting pixels and a plurality of second driving circuits, each effective emitting pixel comprises a plurality of sub-pixels, and the sub-pixels in the effective emitting area are provided to correspond to the second driving circuits one by one.

7. A display device, comprising: the display panel according to claim 6, and an image collection device,
wherein the image collection device is provided in the first area, and located on a side of the display structure away from a light emitting direction.

8. The device according to claim 7, further comprising:
a sensor provided in the first area, the sensor being located on the side of the display structure away from the light emitting direction.

## Patentansprüche

1. Anzeigestruktur (X), umfassend:
eine Vielzahl von Pixeln, welche in einem ersten Bereich (A) der Anzeigestruktur bereitgestellt ist, wobei die Vielzahl von Pixeln in einem 7-Segment-Anzeigemuster angeordnet ist, welches sieben Anzeigesegmente (21, 22, 23, 24, 25, 26, 27) umfasst, wobei jedes Anzeigesegment eine Vielzahl von benachbarten Pixeln umfasst, ein Bereich des voreingestellten Musters kleiner ist als der des ersten Bereichs, jedes Pixel Subpixel mit n Farben umfasst und jedes Subpixel eine organische Leuchtdiode, OLED, umfasst; und
eine Vielzahl von ersten Treiberkreisen, welche in einem zweiten Bereich (B) außerhalb des ersten Bereichs bereitgestellt ist, wobei die Vielzahl von ersten Treiberkreisen n erste Treiberkreise umfasst, die Vielzahl von ersten Treiberkreisen mit den organischen Leuchtdioden verbunden ist, und ein i-ter erster Treiberkreis der n ersten Treiberkreise konfiguriert ist, um die organischen Leuchtdioden in jedem Subpixel einer i-ten Farbe anzutreiben, um Licht zu emittieren, wobei i und n ganze Zahlen sind, und n>1;
für einen Teil der Anzeigesegmente alle Subpixel einer selben Farbe in jedem Anzeigesegment in dem ersten Bereich mit demselben der ersten Treiberkreise in dem zweiten Bereich außerhalb des ersten Bereichs verbunden sind; und
eine Steuereinheit, welche mit der Vielzahl von ersten Treiberkreisen verbunden ist, wobei die Steuereinheit konfiguriert ist, um die Vielzahl von ersten Treiberkreisen zu steuern, um eine oder mehrere organische Leuchtdioden an einem oder mehreren Pixeln einer voreingestellten Position in dem voreingestellten Muster anzutreiben, um Licht zu emittieren.

2. Struktur nach Anspruch 1, wobei jeder der Vielzahl von ersten Treiberkreisen einen Treibertransistor, TFT2, umfasst und jede der organischen Leuchtdioden eine erste Elektrode (6), eine zweite Elektrode (8) und eine organische lichtemittierende Schicht umfasst, welche zwischen der ersten Elektrode und der zweiten Elektrode bereitgestellt ist;
wobei der Treibertransistor in dem i-ten ersten Treiberkreis mit der ersten Elektrode in jedem Subpixel der i-ten Farbe verbunden ist.

3. Struktur nach Anspruch 2, wobei die ersten Elektroden von benachbarten Subpixeln derselben Farbe verbunden sind.

4. Struktur nach Anspruch 1, wobei die Steuereinheit konfiguriert ist, um eine oder mehrere organische Leuchtdioden in einem oder mehreren Pixeln, welche sich in demselben Anzeigesegment befinden, zu steuern, um Licht gleichzeitig zu emittieren oder zu löschen.

5. Struktur nach einem vorstehenden Anspruch, wobei das eine oder die mehreren Pixel in der voreingestellten Position Teil von Pixeln in dem voreingestellten Muster oder alle Pixel in dem voreingestellten Muster sind.

6. Anzeigefeld, umfassend:
die Anzeigestruktur (X) nach einem der Ansprüche 1 bis 5; und
einen effektiv emittierenden Bereich (Y), wobei der effektiv emittierende Bereich mit einer Vielzahl von effektiv emittierenden Pixeln und einer Vielzahl von zweiten Treiberkreisen bereitgestellt ist, jedes effektiv emittierende Pixel eine Vielzahl von Subpixeln umfasst, und die Subpixel in dem effektiv emittierenden Bereich bereitgestellt sind, um nacheinander den zweiten Treiberkreisen zu entsprechen.

7. Anzeigevorrichtung, umfassend: das Anzeigefeld nach Anspruch 6 und eine Bilderfassungsvorrichtung,
wobei die Bilderfassungsvorrichtung in dem ersten Bereich bereitgestellt ist und sich auf einer Seite der Anzeigestruktur befindet, welche von einer Lichtemissionsrichtung abgewandt ist.

8. Vorrichtung nach Anspruch 7, weiter umfassend:
einen in dem ersten Bereich bereitgestellten Sensor, wobei sich der Sensor auf der Seite der Anzeigestruktur befindet, welche von der Lichtemissionsrichtung abgewandt ist.

## Revendications

1. Structure d'affichage (X), comprenant :
une pluralité de pixels, disposés dans une première zone (A) de la structure d'affichage, dans laquelle la pluralité de pixels sont agencés selon un motif d'affichage à 7 segments comprenant sept segments d'affichage (21, 22, 23, 24, 25, 26, 27), chaque segment d'affichage comprenant une pluralité de pixels adjacents, une zone du motif prédéfini est inférieure à celle de la première zone, chaque pixel comprend des sous-pixels de n couleurs et chaque sous-pixel comprend une diode électroluminescente organique, OLED ; et
une pluralité de premiers circuits de pilotage disposés dans une seconde zone (B) à l'extérieur de la première zone, dans laquelle la pluralité de premiers circuits de pilotage comprend n premiers circuits de pilotage, la pluralité de premiers circuits de pilotage sont raccordés aux diodes électroluminescentes organiques et un i^{ème} premier circuit de pilotage des n premiers circuits de pilotage est configuré pour piloter les diodes électroluminescentes organiques dans chaque sous-pixel d'une i^{ème} couleur pour émettre de la lumière, dans laquelle i et n sont des nombres entiers, et n > 1 ;
pour une partie des segments d'affichage, tous les sous-pixels d'une même couleur dans chaque segment d'affichage dans la première zone sont raccordés au même des premiers circuits de pilotage dans la seconde zone à l'extérieur de la première zone ; et
une unité de commande raccordée à la pluralité de premiers circuits de pilotage, l'unité de commande étant configurée pour commander la pluralité de premiers circuits de pilotage pour piloter une ou plusieurs diodes électroluminescentes organiques au niveau d'un ou de plusieurs pixels d'une position prédéfinie dans le motif prédéfini pour émettre de la lumière.

2. Structure selon la revendication 1, dans laquelle chacun de la pluralité de premiers circuits de pilotage comprend un transistor de pilotage, TFT2, et chacune des diodes électroluminescentes organiques comprend une première électrode (6), une seconde électrode (8) et une couche électroluminescente organique disposée entre la première électrode et la seconde électrode ;
dans laquelle le transistor de pilotage dans le i^{ème} premier circuit de pilotage est raccordé à la première électrode dans chaque sous-pixel de la i^{ème} couleur.

3. Structure selon la revendication 2, dans laquelle les premières électrodes de sous-pixels voisins de la même couleur sont raccordées.

4. Structure selon la revendication 1, dans laquelle l'unité de commande est configurée pour commander une ou plusieurs diodes électroluminescentes organiques dans un ou plusieurs pixels situés dans le même segment d'affichage pour émettre ou éteindre de la lumière simultanément.

5. Structure selon une quelconque revendication précédente, dans laquelle les un ou plusieurs pixels dans la position prédéfinie font partie de pixels dans le motif prédéfini, ou sont tous les pixels dans le motif prédéfini.

6. Panneau d'affichage, comprenant :
la structure d'affichage (X) selon l'une quelconque des revendications 1 à 5 ; et
une zone d'émission effective (Y), dans lequel la zone d'émission effective est dotée d'une pluralité de pixels d'émission effective et d'une pluralité de seconds circuits de pilotage, chaque pixel d'émission effective comprend une pluralité de sous-pixels et les sous-pixels dans la zone d'émission effective sont disposés pour correspondre aux seconds circuits de pilotage un par un.

7. Dispositif d'affichage, comprenant : le panneau d'affichage selon la revendication 6, et un dispositif de collecte d'image,
dans lequel le dispositif de collecte d'image est disposé dans la première zone et situé sur un côté de la structure d'affichage éloigné d'une direction d'émission de lumière.

8. Dispositif selon la revendication 7, comprenant en outre :
un capteur disposé dans la première zone, le capteur étant situé sur le côté de la structure d'affichage éloigné de la direction d'émission de lumière.
